# EUROPEAN PATENT APPLICATION

(11) **EP 4 266 839 A1**
(43) Date of publication of application: **25.10.2023**
(21) Application number: 22465532.4
(22) Date of filing: 21.04.2022
(51) Int. Cl.: H05K 3/24

(54) **METHOD FOR APPLYING AN ELECTROCHEMICAL PROCESS**

(71) Applicant: Continental Automotive Technologies GmbH, 30165 Hannover (DE)
(72) Inventor: Sipilä, Pekka, 81737 München (DE); Nitzschke, Michael, 81737 München (DE); Helfrich, Ludwig, 81737 München (DE); Bebendorf, Markus, 81737 München (DE); Moisa, Cosmin, 81737 München (DE)
(74) Representative: Continental Corporation

(57) **Abstract**

The invention relates to a method for applying an electrochemical process on a plurality of conductors on a circuit board, wherein the circuit board is at least partially covered with a mesh arrangement comprised of electrically conducting wires before, and especially while, applying the electrochemical process.

## Description

The invention relates to a method for applying an electrochemical process on a plurality of conductors on a circuit board.

When applying electrochemical processes for complete circuit boards, the process may be applied to a plurality of conductors which have no electric connection to each other. Especially, such conductors may be used for contacting passive or active electronic components like resistors, capacitors, or processors with each other and with other components.

It is an object of the invention to provide for a method for applying an electrochemical process that is better or alternative compared to known solutions. This is achieved by a method according to claim 1. Preferred embodiments can, for example, be derived from the respective dependent claims. The content of the claims is made a content of the description by explicit reference.

The invention relates to a method for applying an electrochemical process on a plurality of conductors on a circuit board. The method comprises the following steps:
- covering the circuit board, at least partially, with a mesh arrangement,
   wherein the mesh arrangement is, at least partially, comprised of electrically conducting wires,
- applying the electrochemical process, and
- removing the mesh arrangement.

With such a method, the mesh can be used in order to put the conductors on the circuit board on a specific and/or similar potential. This can omit a situation in which the electrochemical process is applied in a state with all the conductors having different electric potential. This can lead to a better and smoother growth of small wires or other intended effects of the electrochemical process.

An electrochemical process can, for example, be a process which grows small needles on the conductors. This can especially be used in order to ease connection to other components, for example before, or instead of, soldering connections on the conductors. The conductors can especially be conducting wires and/or conducting pads, or arrangements of such entities. In principle, a conductor can be any conducting entity being placed on a circuit board. The circuit board is typically a planar object; however, it can also have a different shape.

An exemplary electrochemical process may be used to grow a lawn of metallic nanowires or whisker. The process may be initiated with a sponge soaked with an electrolyte. The sponge has a special nanostructure that defines the characteristics of the lawn of nanowires, which emerges through electrochemical reaction when this sponge is brought in contact with a conductive surface, e.g., electric pad on a printed circuit board, and an electric potential difference is applied between this conductive surface and the electrolyte-soaked sponge.

The mesh arrangement can especially be a mesh, or a mesh together with other components, for example handling means. The circuit board can especially be covered completely with the mesh arrangement. Alternatively, the circuit board may be covered only at places where conductors are present. The mesh arrangement may also be completely comprised of electrically conducting wires.

Removing the mesh arrangement may especially mean that the mesh arrangement is brought out of contact with the circuit board. Thus, other components can be placed on the circuit board, for example electric or electronic components.

Especially, the mesh arrangement may be formed as a two-dimensional mesh. This can especially mean that the mesh has, at least in a ground state, a flat shape, especially when lying on a flat table. Especially, it may have a certain thickness, which is much less than its dimensions in a plane perpendicular to the direction in which the thickness is measured. Especially, a two-dimensional object can be regarded as an opposite to a sponge, which is a three-dimensional object.

The wires may be round wires and/or may have a round cross-section. However, they may also be flat structures and/or may have a rectangular cross-section. For example, they may be made of a metal foil or metal foils. The mesh structure may, for example, be achieved by stamping.

The mesh arrangement may especially have a mesh size being smaller than the smallest feature size of the conductors on the circuit board. This can ensure that all conductors are connected by the mesh arrangement, so that they can be put on the same electric potential. If only a part of the conductors should be activated for the electrochemical process, the feature size may be smaller than the smallest feature size of these conductors to be activated. In general, references to conductors can be read such that only conductors that should be subject to the electrochemical process are to be considered.

Especially, the mesh arrangement can, while covering the circuit board, electrically connect all conductors on the circuit board to each other. Thus, all the conductors can be put on the same electric potential, which can significantly improve the electrochemical process.

Especially, the electrically conducting wires of the mesh arrangement may be uninsulated. This allows electric contact between the wires and the conductors. They can be completely or partly uninsulated.

Especially, the mesh arrangement can form a complete electrically conducting entity. Such a complete electrically conducting entity can especially mean that all elements of the mesh arrangement are electrically conducting. Especially, they can all be uninsulated. However, there is also an option that the mesh arrangement is conductive only on one side. Typically, this will be the side facing the circuit board. The other side can be insulating, for example through a lacquer.

The electrochemical process may be applied while the mesh covers the circuit board. This includes that the mesh covers the circuit board in parts that should be subject to the electrochemical process and/or should be electrically connected together by the mesh. Thus, the effect of equalizing electric potentials between the conductors can be upheld while the electrochemical process is applied.

The mesh arrangement may especially be grounded, or set to a specific electric potential, before and/or while applying the electrochemical process. Thus, a defined electric potential can be applied. This can even be used in order to specifically support the electrochemical process. If the mesh arrangement is grounded, this usually means that the electric potential is set to zero volts, especially with regard to a global reference.

Especially, the mesh arrangement may be pressed on the circuit board before and/or while applying the electrochemical process. The mesh arrangement may especially be pressed with uniformly distributed pressure. This can ensure electric contact between the mesh arrangement and the conductors. Especially, the mesh arrangement may be pressed using a sponge, which may comprise chemical substances for the electrochemical process.

Especially, the mesh arrangement may have a maximum diameter of the conducting wires being such that the maximum total value of the wire radius plus the half of the distance between the wires is smaller than the half of the minimum feature size of the conductors on the circuit board. Thus, a secure connection of the conductors can be ensured, while at the same time leaving enough room for performing the electrochemical process. Any dimension defining a distance between outlines of conductors may be regarded as a feature size. The smallest value found on the circuit board, or on the relevant part of the circuit board, may be used as the minimum feature size.

Especially, the conductors may be electrically separate on the circuit board. Thus, they can be temporarily electrically connected using the mesh arrangement. Especially, the conductors may be arranged on the circuit board in pads and/or lines. Such pads or lines form typical components of a conductor structure on a circuit board.

Especially, it should be noted that a mesh of (semi-)conducting material onto the circuit board during an electrochemical process can be applied. For example, the electrolyte for the electrochemical process can be applied by a wetted sponge with a specific electrolyte in it. The mesh structure can be introduced in between the sponge and the printed circuit board. Alternatively to a sponge, a porous film could be used. Typically, the mesh may be equally pressed over the whole circuit board (or segments, for which the process needs to be applied for) to ensure a proper electric contact with the mesh and the contact pads on the circuit board. The mesh can be conductive enough for transferring the electrons/holes/ions for the process, yet it should preferably be electrochemically inert to the process. The mesh can especially be made of another material than the contact pads, but inert materials such as gold or platinum could be considered, or special alloys or ceramics such as indium-tin-oxide, or non-metals such as carbon/graphene/graphite etc. It is preferable for the mesh size that the pitch of the mesh-threads is smaller than the minimum layout feature size to ensure that regardless of the design geometry the electric pad is contacted at some point to the mesh. The second requirement is that the mesh wire should be as thin as possible (yet thick enough to carry enough charge carriers per unit time).

The electrochemical process can especially grow nanowire lawns for complex circuit boards with a high number of electric contacts, for example more than ten electric contacts. It can be used also for repair work of broken electronics where rejoining of components or boards to a carrier board, e.g., motherboards, is needed. As the electrochemical process takes time, the process can also be applied during transportation, for example during transportation of the circuit board between a supplier and an assembler. The electrochemical process can also be applied during intermediate storage. A sponge or film, wetted with electrolyte, may be pressed between the circuit board and the lid/cover of the transportation box, a battery may be connected between the sponge and the circuit board, and a mesh can be applied as described before to contact every possible contacts. Multiple circuit boards can be treated with a sandwich-type of a structure.

The invention relates further to a circuit board fabricated using a method as described herein. With regard to the method, all disclosed embodiments and variations can be applied.

Further advantages and details may be derived from the embodiment described further below with respect to the accompanying drawing.

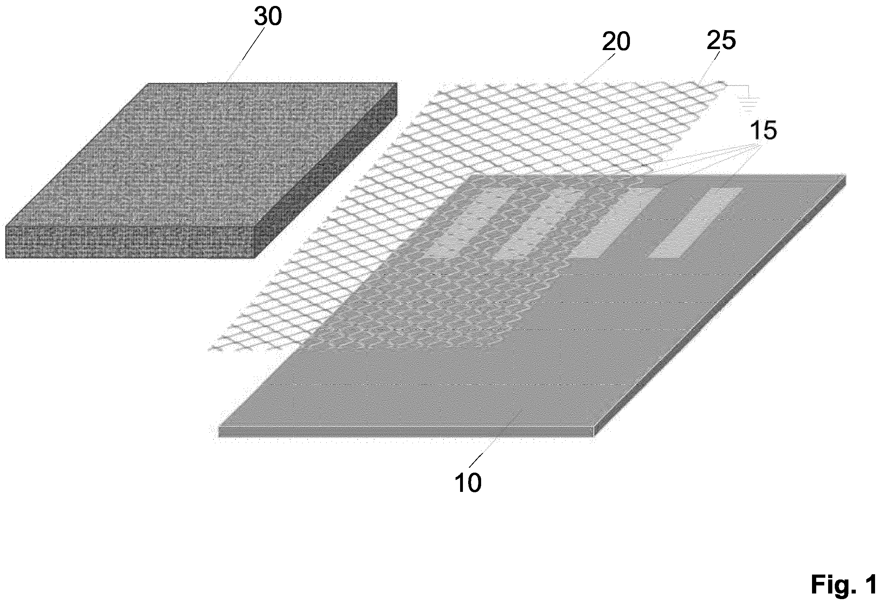

- Fig. 1:: shows an arrangement of a circuit board, a mesh arrangement, and a sponge.

Fig. 1 shows a circuit board 10, on which several conductors 15 are present. These conductors are shown as stripes; however, they can also have any other suitable form.

Over the circuit board 10, there is a mesh arrangement 20. The mesh arrangement 20 is a two-dimensional mesh having a grid size being smaller than the extensions of the conductors 15 and the distances between them. The mesh arrangement 20 can be put on the circuit board 10, so that the conductors 15, which are in a normal state not electrically connected to each other, are electrically connected, due to the fact that the mesh arrangement 20 is formed of electrically conducting wires 25.

A sponge 30 may be used in order to initiate an electrochemical process. For example, it may be pressed on the mesh arrangement 20, so that the mesh arrangement 20 is also pressed against the circuit board 10. Thus, all the conductors 15 get the desired electric potential for the electrochemical process.

The mesh arrangement 20 can especially be pressed between the circuit board 10 and the sponge 30. Ideally, it is electrochemically inert versus the material of the conductors 15 and any used electrolyte or other chemical substance. It can even be carbon-based, for example it can be a graphene mesh. Especially, it may be connected to an electric potential, e.g., a voltage source or a ground. In the embodiment shown in fig. 1, the mesh arrangement 20 is grounded.

Mentioned steps of the inventive method can be performed in the given order. However, they can also be performed in another order, as long as this is technically reasonable. The inventive method can, in an embodiment, for example with a certain combination of steps, be performed in such a way that no further steps are performed. However, also other steps may be performed, including steps that are not mentioned.

It is to be noted that features may be described in combination in the claims and in the description, for example in order to provide for better understandability, despite the fact that these features may be used or implemented independent from each other. The person skilled in the art will note that such features can be combined with other features or feature combinations independent from each other.

References in dependent claims may indicate preferred combinations of the respective features, but do not exclude other feature combinations.

### List of reference signs

- 10: circuit board
- 15: conductors
- 20: mesh arrangement
- 25: conducting wires
- 30: sponge

## Claims

1. Method for applying an electrochemical process on a plurality of conductors (15) on a circuit board (10),
the method comprising the following steps:
- covering the circuit board (10), at least partially, with a mesh arrangement (20), wherein the mesh arrangement (20) is, at least partially, comprised of electrically conducting wires (25),
- applying the electrochemical process, and
- removing the mesh arrangement (20).

2. Method according to claim 1,
- wherein the mesh arrangement (20) is formed as a two-dimensional mesh.

3. Method according to one of the preceding claims,
- wherein the mesh arrangement (20) has a mesh size being smaller than the smallest distance between electrically separate conductors (15) on the circuit board (10).

4. Method according to one of the preceding claims,
- wherein the mesh arrangement (20), while covering the circuit board (10), electrically connects all conductors (15) on the circuit board (10) to each other.

5. Method according to one of the preceding claims,
- wherein the electrically conducting wires (25) of the mesh arrangement (20) are uninsulated.

6. Method according to one of the preceding claims,
- wherein the mesh arrangement (20) forms a complete electrically conducting entity.

7. Method according to one of the preceding claims,
- wherein the electrochemical process is applied while the mesh covers the circuit board (10).

8. Method according to one of the preceding claims,
- wherein the mesh arrangement (20) is grounded, or set to a specified electric potential, before and/or while applying the electrochemical process.

9. Method according to one of the preceding claims,
- wherein the mesh arrangement (20) is pressed, or pressed with uniformly distributed pressure, on the circuit board (10) before and/or while applying the electrochemical process.

10. Method according to one of the preceding claims,
- wherein the mesh arrangement (20) has a maximum diameter of the conducting wires (25) being such that the maximum total value of the wire radius plus the half of the distance between the wires is smaller than the half of the minimum feature size of the conductors (15) on the circuit board (10).
